# EUROPÄISCHE PATENTSCHRIFT

(11) **EP 2 899 559 B1**
(45) Veröffentlichungstag und Bekanntmachung des Hinweises auf die Patenterteilung: **15.06.2016**
(21) Anmeldenummer: 14190664.4
(22) Anmeldetag: 28.10.2014
(51) Int. Cl.: G01R 31/42, H02M 1/32, H02M 7/5387, B60L 3/00, G01R 19/165, H02M 7/48

(54) **Verfahren zur Diagnose eines Umrichters**
Method for diagnosing a converter
Procédé de diagnostic d'un convertisseur

(30) Priorität: 28.01.2014 DE 102014201500
(43) Veröffentlichungstag der Anmeldung: 29.07.2015
(73) Patentinhaber: Dr. Johannes Heidenhain GmbH, 83301 Traunreut (DE)
(72) Erfinder: Ritz, Franz, 83236 Übersee (DE); Huber, Norbert, 83317 Teisendorf (DE)

(56) Entgegenhaltungen:
- EP-A1- 0 848 492
- DE-A1-102013 212 096
- JP-A- H06 261 404

## Beschreibung

### GEBIET DER TECHNIK

Die vorliegende Erfindung betrifft ein Verfahren zur Diagnose von Fehlern in einem Umrichter. Solche Verfahren dienen dazu, im Falle eines Fehlers die Fehlerquelle schnell zu lokalisieren.

### STAND DER TECHNIK

In modernen Werkzeugmaschinen werden elektrische Antriebe verwendet, um verschiedene Maschinenteile kontrolliert zu bewegen. So sorgen die Achsantriebe dafür, dass die einzelnen Achsen der Werkzeugmaschine in die geforderten Positionen bewegt werden. Spindelantriebe sorgen für die Drehbewegung eines Werkzeuges wie beispielsweise eines Fräsers oder Bohrers. Eine Numerische Steuerung setzt hierzu die einem Teileprogramm vorgegebenen Bewegungen in Lagesollwerte um, die einer Regeleinheit aus Lage-, Drehzahl- und Stromregler übergeben werden. Im Stromregler werden Spannungssollwerte für einzelne Motorphasen generiert, die von einem Umrichter mittels der sogenannten Pulsweitenmodulation umgesetzt werden.

Ein Umrichter bezieht elektrische Energie aus einem mehrphasigen Wechselstromnetz, indem zunächst mittels eines Gleichrichters eine Gleichspannung erzeugt wird, mit der ein Zwischenkreiskondensator auf eine gewünschte Zwischenkreisspannung geladen wird. Mittels eines Wechselrichters sind die Phasen eines Motors über je zwei Schaltelemente mit der positiven und negativen Zwischenkreisspannung verbunden. Die Schalter werden nach dem Muster der Pulsweitenmodulation (PWM) geeignet geschaltet, um an jeder Phase eines Motors das geforderte Spannungspotential zu erzeugen, das nötig ist, um die Stromsollwerte im Motor zu erreichen. Die tatsächlichen Motorströme werden am Ausgang des Umrichters gemessen und an den Stromregler zurück gemeldet.

Es sind im Stand der Technik verschiedene Verfahren bekannt, um einen Umrichter auf seine Funktionsfähigkeit zu überprüfen und um im Fehlerfall die Fehlerquelle lokalisieren zu können.

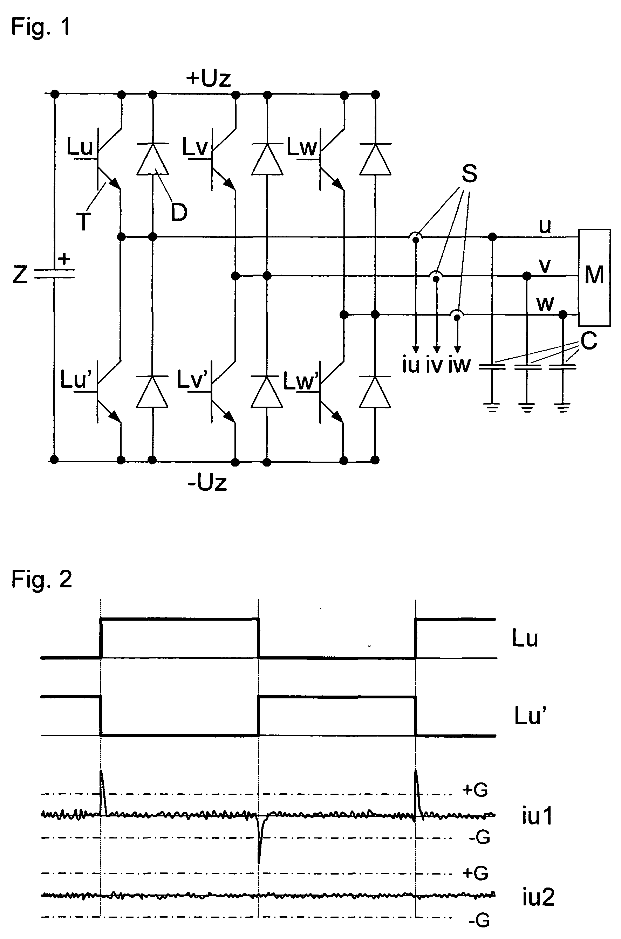

So ist in der DE 10148740 B4 eine Ladeschaltung für den Zwischenkreis eines Umrichters angegeben, die einen Erdschluss im Motor erkennen kann. Der aus dem Stand der Technik bekannte Aufbau eines Umrichters mit Gleichrichter, Zwischenkreis und Wechselrichter ist hier z.B. in der Figur 1 zusammen mit dem speisenden Netz und dem angeschlossenen Motor dargestellt.

In der EP 1355163 B1 ist ein Verfahren und eine Vorrichtung angegeben, mit der ein Umrichter auf seine Funktionsfähigkeit überprüft werden soll. Hierzu werden bei geladenem Zwischenkreis PWM - Testmuster an die Schaltelemente des Wechselrichters ausgegeben. Die dabei an den Motoranschlüssen auftretende Spannung wird mittels kapazitiver Sensoren erfasst und mit einem erwarteten Spannungsmuster verglichen. Auch wenn dieses Verfahren mit nur einer einzigen, kapazitiv an die Motoranschlüsse gekoppelten Prüfleitung und einem entsprechenden Spannungsmesser auskommt, so ist doch ein gewisser zusätzlicher Aufwand für die Installation dieser Komponenten zu treiben.

Die EP 0848492 A1 beschreibt ein Verfahren zum Diagnostizieren von Fehlern in einem Umrichter, bei dem auf die zeitliche Änderung des in Sensoren gemessenen Stromes geachtet wird. Ein Fehler wird erkannt, wenn dieser Anstieg einen Grenzwert nicht überschreitet.

In der DE 102013212096 A1 wird ein Elektrofahrzeug beschrieben, dessen Spannungswandler anhand von abgespeicherten Strom- und Spannungsmessdaten überprüft wird. Diese gespeicherten Daten entsprechen einem korrekt arbeitenden Spannungswandler und werden mit aktuell gemessenen Daten verglichen.

Ein Fehlertyp, den es häufig zu prüfen gilt, ist die Frage, ob ein trotz entsprechender Ansteuerung still stehender Motor auf eine fehlende Zwischenkreisspannung zurück zu führen ist, oder ob ein anderer Fehler vorliegt, wie etwa ein nicht richtig angeschlossener Motor. Da die Zwischenkreisspannung in einem Umrichter typischerweise in einem Bereich von einigen 100 V liegt, ist eine direkte Messung aufwändig. Es ist in der Regel aus Sicherheitsgründen eine galvanische Trennung von der nachfolgenden Auswerteelektronik notwendig.

### ZUSAMMENFASSUNG DER ERFINDUNG

Aufgabe der Erfindung ist es daher, eine Diagnosemöglichkeit für die Zwischenkreisspannung eines Umrichters zu schaffen, die ohne oder mit wenigen zusätzlichen Komponenten auskommt.

Diese Aufgabe wird gelöst durch ein Verfahren gemäß Anspruch 1. Vorteilhafte Details dieses Verfahrens ergeben sich auch aus den von Anspruch 1 abhängigen Ansprüchen.

Es wird ein Verfahren zur Diagnose eines Umrichters angegeben, dessen positive und negative Zwischenkreisspannung über Brücken aus Schaltelementen alternierend an Phasen eines Motors angelegt wird, indem die Schaltelemente einer Phase mit PWM-Signalen angesteuert werden, wobei Stromsensoren die Phasenströme erfassen. Das Verfahren umfasst die Schritte:
- Anlegen von PWM-Signalen als Testmuster an die Schaltelemente,
- Aufnehmen von Sensorsignalen mittels der Stromsensoren,
- Auswerten der Sensorsignale, indem das Anliegen der Zwischenkreisspannung festgestellt wird, wenn in den Sensorsignalen ein Verschiebungsstrom erkannt wird.

Ein Verschiebungsstrom in den Stromsensoren des Umrichters kann nur auftreten, wenn tatsächlich eine Zwischenkreisspannung anliegt. Fehlen diese Verschiebungsströme, die jeweils zu den Flanken der als Testmuster verwendeten PWM-Signale auftreten sollten, so liegt das Fehlen der Zwischenkreisspannung nahe.

Durch einen Vergleich der Amplitude der Verschiebungsströme lässt sich sogar erkennen, wenn nur einzelne Phasen eines Motors angeschlossen sind, und andere nicht. So führt eine angeschlossene Motorphase zu einem höheren Verschiebungsstrom im Umrichter als an den Anschlüssen, an denen keine Motorphase angeschlossen ist. Fehlt hingegen eine Motorphase, so wird der Verschiebungsstrom an der betreffenden Anschlussklemme des Umrichters kleiner sein als in den anderen, angeschlossenen Phasen.

Weitere Vorteile und Einzelheiten der vorliegenden Erfindung ergeben sich aus der nachfolgenden Beschreibung verschiedener Ausführungsformen anhand der Figuren.

### KURZE BESCHREIBUNG DER ZEICHNUNGEN

Dabei zeigt
Figur 1 einen Umrichter mit angeschlossenem Motor,
Figur 2 ein PWM - Testmuster und Ströme, die am Umrichter gemessen werden.

### BESCHREIBUNG DER AUSFÜHRUNGSFORMEN

Die Figur 1 zeigt den Zwischenkreis Z eines Umrichters, an den ein Wechselrichter angeschlossen ist. Die Phasen u, v, w eines Motors M sind über je zwei Schaltelemente T des Wechselrichters sowohl mit der positiven als auch der negativen Zwischenkreisspannung +Uz, -Uz verbunden. Parallel zu den Schaltelementen T sind wie üblich Freilaufdioden D geschaltet. Die Schaltelemente T werden mit logischen Signalen Lu, Lv und Lw (bzw. mit deren logischem Gegenteil Lu', Lv', Lw') angesteuert, wobei die beiden Schaltelemente T einer Phase u, v, w jeweils gegensinnig und unter Einhaltung einer kurzen Totzeit angesteuert werden, so dass niemals beide Schaltelemente T einer Phase u, v, w leitend sind.

In der Figur 1 sind außerdem die Sensoren S gezeigt, mit denen in jeder Phase u, v, w der Richtung Motor M fließende Strom iu, iv, iw gemessen wird, um den Stromregelkreis zu schließen. Oft werden dazu nur zwei von drei Phasen gemessen, denn der Strom der dritten Phase sollte die Summe der beiden anderen Phasen sein. Die Stromsensoren S sind üblicherweise am Ausgang des Umrichters, in der Nähe der Anschlussklemmen des Motors M angeordnet.

Wenn nun ein Fehler auftritt, der darin besteht, dass sich ein Motor nicht bewegt, obwohl im Umrichter entsprechende PWM - Signale an den Schaltelementen T anliegen, so kann die Fehlerquelle eine fehlende Zwischenkreisspannung +Uz, -Uz sein, es kann aber auch schlicht der Motor nicht angeschlossen bzw. das Motorkabel unterbrochen sein.

Eine direkte Prüfung der Zwischenkreisspannung +Uz, -Uz durch Messung ist wegen der hierfür notwendigen galvanischen Trennung aufwändig, auch deshalb ist ein anderes Verfahren für die Eingrenzung des Fehlers wünschenswert.

Das Verfahren zur Diagnose des Umrichters besteht nun - grob in drei Schritte eingeteilt - darin, an die Schaltelemente T des Umrichters ein Testmuster auszugeben (Schritt a), dabei die Signale der Stromsensoren zu erfassen (Schritt b) und zu beurteilen (Schritt c).

In der Figur 2 sind das Testmuster und die Sensorsignale dargestellt. Dabei wurde die Darstellung auf eine Motorphase u begrenzt, denn die anderen Phasen werden wenn nötig auf die gleiche Weise überprüft.

### Schritt a)

An die Schaltelemente T einer Motorphase u werden die gegensinnigen PWM - Signale Lu bzw. Lu' angelegt. Dies geschieht vorzugsweise synchron für alle Phasen u, v, w, da andernfalls ein Rippelstrom zwischen den Phasen fließen würde, der die Auswertung von Verschiebungsströmen erschweren würde.

Die gegensinnigen PWM - Signale Lu bzw. Lu' sollten außerdem ein Tastverhältnis von 50% aufweisen, da sich dann am Ausgang des Umrichters eine Spannung von 0V einstellt. Die Motorphase u wird so gleichmäßig zwischen der positiven und negativen Zwischenkreisspannung +Uz, -Uz hin und her geschaltet.

### Schritt b)

Die Signale iu, iv, iw des Stromsensors S werden aufgenommen. Ist eine Zwischenkreisspannung +Uz, -Uz vorhanden, aber z.B. der Motor M nicht an der Phase u angeschlossen, so bewirkt die am Ausgang des Umrichters anliegende Wechselspannung einen Verschiebungsstrom, der als Sensorsignal iu1 vom Stromsensor S aufgenommen wird. Dieser Verschiebungsstrom fließt durch die Kapazität C gegen Erde bzw. gegen den Zwischenkreis Z. Die Kapazität C kann durch fest eingebaute Kondensatoren gebildet werden, oder einfach durch Streukapazitäten, die z.B. durch ein geeignetes Layout von Kupferflächen auf der Platine des Umrichters gezielt unterstützt werden können.

Zur Detektion des Verschiebungsstromes wird der Stromsensor S der Motorphase u herangezogen, es ist hierfür also kein zusätzlicher Aufwand nötig.

Ist hingegen keine Zwischenkreisspannung +Uz, -Uz vorhanden, so wird durch das Anlegen der PWM-Signale Lu, Lu' kein Verschiebungsstrom erzeugt, so dass der Stromsensor S lediglich Rauschen detektiert, entsprechend dem Sensorsignal iu2 der Figur 2.

### Schritt c)

Es erfolgt also eine Auswertung des Sensorsignales dahingehend, ob wie beim Signal iu1 Stromspitzen bei den Umschaltungen des Logikpegels des PWM-Signals auftreten, oder eben wie beim Signal iu2 nicht.

Im ersten Fall ist eine fehlende Zwischenkreisspannung +Uz, -Uz ohne direkte Messung derselben ausgeschlossen, und damit z.B. der nicht richtig angeschlossene Motor M eine mögliche Fehlerquelle.

Im zweiten Fall ist die fehlende Zwischenkreisspannung +Uz, -Uz die wahrscheinliche Fehlerquelle.

Die Detektion der Stromspitzen kann durch eine einfache Überwachung von Grenzwerten +/- G erfolgen, deren Über- bzw. Unterschreitung durch das Sensorsignal iu1 einen Verschiebungsstrom anzeigt. Um die Detektion sicher gegenüber Störsignalen in den Stromsensoren S zu gestalten, kann auch auf den Zeitpunkt der Über- bzw. Unterschreitung der Grenzwerte +/-G geachtet werden, da diese mit der Umschaltung der PWM-Signale Lu, Lu' zeitlich korrelieren müssen. Eine mehrfache Übereinstimmung von Stromspitzen mit den Flanken des PWM-Signals ist ein sehr sicheres Indiz für einen Verschiebungsstrom.

Ermittelt man zusätzlich die Höhe der Stromspitzen in den verschiedenen Phasen, etwa durch die Verwendung mehrerer Grenzwerte unterschiedlichen Betrages, so lassen sich wie oben beschrieben auch einzelne nicht richtig angeschlossene Motorphasen identifizieren, da eine angeschlossene Motorphase zu einem höheren Verschiebungsstrom führt als bei einer offenen Anschlussklemme des Umrichters.

## Patentansprüche

1. Verfahren zur Diagnose eines Umrichters, dessen positive und negative Zwischenkreisspannung (+Uz, -Uz) über Brücken aus Schaltelementen (T) alternierend an Phasen (u, v, w) eines Motors (M) angelegt wird, indem die Schaltelemente (T) einer Phase (u, v, w) mit PWM-Signalen angesteuert werden, wobei Stromsensoren (S) die Phasenströme (iu, iv, iw) erfassen, mit folgenden Schritten:
a) Anlegen von PWM-Signalen als Testmuster (Lu, Lu') an die Schaltelemente (T),
b) Aufnehmen von Sensorsignalen (iu1, iu2) mittels der Stromsensoren, **gekennzeichnet durch** den weiteren Schritt
c) Auswerten der Sensorsignale (iu1, iu2), indem das Anliegen der Zwischenkreisspannung (+Uz, -Uz) festgestellt wird, wenn in den Sensorsignalen (iu1, iu2) ein Verschiebungsstrom erkannt wird, wobei die Auswertung der Sensorsignale (iu1, iu2) **durch** eine Detektion von Stromspitzen erfolgt, die **durch** Verschiebungsströme verursacht sind, und wobei detektierte Stromspitzen zeitlich mit Flanken des Testmusters (Lu. Lu') zusammen fallen müssen, um einen Verschiebungsstrom zu erkennen.

2. Verfahren nach Anspruch 1, **dadurch gekennzeichnet, dass** in Schritt a) das Testmuster (Lu, Lu') ein Tastverhältnis von 50% aufweist.

3. Verfahren nach Anspruch 1 oder 2, **dadurch gekennzeichnet, dass** in Schritt a) das Testmuster (Lu, Lu') synchron für alle Motorphasen (u, v, w) ausgegeben wird.

4. Verfahren nach einem der vorhergehenden Ansprüche, **dadurch gekennzeichnet, dass** die Detektion von Stromspitzen durch einen Vergleich des Sensorsignals (iu1, iu2) mit Grenzwerten (+G, -G) erfolgt.

## Claims

1. Method for diagnosing a converter whose positive and negative intermediate circuit voltage (+Uz, -Uz) is applied alternately to phases (u, v, w) of a motor (M) via bridges comprising switching elements (T) by virtue of the switching elements (T) of a phase (u, v, w) being driven with PWM signals, wherein current sensors (S) detect the phase currents (iu, iv, iw), comprising the following steps:
a) applying PWM signals as a test pattern (Lu, Lu') to the switching elements (T),
b) picking up sensor signals (iu1, iu2) by means of the current sensors,
**characterized by** the following further step:
c) evaluating the sensor signals (iu1, iu2) by establishing the presence of the intermediate circuit voltage (+Uz, -Uz) if a displacement current is identified in the sensor signals (iu1, iu2), wherein the evaluation of the sensor signals (iu1, iu2) is effected by a detection of current spikes caused by displacement currents, and wherein detected current spikes must coincide temporally with edges of the test pattern (Lu, Lu') in order to identify a displacement current.

2. Method according to Claim 1, **characterized in that** in step a) the test pattern (Lu, Lu') has a duty radio of 50%.

3. Method according to Claim 1 or 2, **characterized in that** in step a) the test pattern (Lu, Lu') is output synchronously for all motor phases (u, v, w).

4. Method according to any of the preceding claims, **characterized in that** the detection of current spikes is effected by a comparison of the sensor signal (iu1, iu2) with limit values (+G, -G).

## Revendications

1. Procédé de diagnostic d'un convertisseur dont les tensions de circuit intermédiaires positive et négative (+Uz, -Uz) sont alternativement appliquées par l'intermédiaire de ponts constitués d'éléments de commutation (T) à des phases (u, v, w) d'un moteur (M) en attaquent les éléments de commutation (T) d'une phase (u, v, w) avec des signaux PWM, dans lequel des capteurs de courant (S) détectent les courants de phase (iu, iv, iw), comprenant les étapes consistant à :
a) appliquer des signaux PWM, en tant que configurations de test (Lu, Lu'), aux éléments de commutation (T),
b) acquérir des signaux de capteurs (iu1, iu2) au moyen des capteurs de courant,
**caractérisé par** les étapes consistant à :
c) évaluer les signaux de capteurs (iu1, iu2) en fixant l'application de la tension de circuit intermédiaire (+Uz, -Uz) à l'instant où un courant de déplacement est reconnu dans les signaux de capteurs (iu1, iu2), dans lequel l'évaluation des signaux de capteurs (iu1, iu2) est effectuée par une détection de pics de courant provoqués par des courants de déplacement, et dans lequel des pics de courant détectés doivent coïncider temporellement avec des fronts de la configuration de test (Lu, Lu') pour qu'un courant de déplacement soit reconnu.

2. Procédé selon la revendication 1, **caractérisé en ce que**, lors de l'étape a), la configuration de test (Lu, Lu') présente un rapport cyclique de 50%.

3. Procédé selon la revendication 1 ou 2, **caractérisé en ce que**, lors de l'étape a), la configuration de test (Lu, Lu') est délivrée en synchronisme pour toutes les phases (u, v, w) du moteur.

4. Procédé selon l'une quelconque des revendications précédentes, **caractérisé en ce que** la détection de pics de courant est effectuée par comparaison du signal de capteur (lu1, lu2) à des valeurs limites (+G, -G).
